# EUROPEAN PATENT APPLICATION

(11) **EP 4 797 589 A1**
(43) Date of publication of application: **26.08.2026**
(21) Application number: 26157231.7
(22) Date of filing: 09.02.2026
(51) Int. Cl.: H04L 1/00, H03M 13/13

(54) **DETECTING TRANSMISSIONS USING GEOMETRIC TRANSFORMATIONS IN SOFT BIT DECODING**

(30) Priority: 19.02.2025 FI 20255143
(71) Applicant: Nokia Solutions and Networks Oy, 02610 Espoo (FI)
(72) Inventor: KORPI, Dani Johannes, Tampere (FI); HONKALA, Mikko Johannes, Espoo (FI)
(74) Representative: Nokia EPO representatives

(57) **Abstract**

Disclosed is a method comprising determining in accordance with a modulation scheme a candidate set of soft bit blocks representing at least part of the data, wherein an application of each geometric transformation operation of a set of geometric transformation operations to a corresponding subset of the set of constellation points or to the set of constellation points, preserves the shape of the modulation constellation but results in representing different data, for each geometric transformation operation of the set of geometric transformation operations, modifying according to the geometric transformation operation corresponding soft bit blocks of the candidate set of soft bit blocks resulting in another candidate set of soft bit blocks, and selecting from the candidate sets of soft bit blocks the candidate set of soft bit blocks that likely represents the at least part of the data.

## Description

### TECHNICAL FIELD

Various example embodiments relate to telecommunication systems, and more particularly to an apparatus for reception of data in a wireless communication system.

### BACKGROUND

A wireless communication system includes nodes such as base stations, wherein each node may serve devices located within the node's geographical area of service. The wireless communication system may support one or more radio access technologies (RATs). An example radio access technology may include evolved universal terrestrial radio access (E-UTRA), fifth-generation wireless networks (5G) new radio (NR), or a sixth-generation wireless networks (6G) based system, but is not limited thereto, as a person skilled in the art may apply the present subject matter to other wireless communication systems provided with necessary properties.

### SUMMARY

Example embodiments provide an apparatus for reception of data in a wireless communication system, the apparatus comprising at least one processor; and at least one memory storing instructions that, when executed by the at least one processor, cause the apparatus to: determine in accordance with a modulation scheme a candidate set of soft bit blocks representing at least part of the data, the candidate set of soft bit blocks representing a set of constellation points in a modulation constellation of the modulation scheme, wherein an application of each geometric transformation operation of a set of geometric transformation operations to a corresponding subset of the set of constellation points or to the set of constellation points preserves the shape of the modulation constellation but results data being represented differently; for each geometric transformation operation of the set of geometric transformation operations, modify according to the geometric transformation operation corresponding soft bit blocks of the candidate set of soft bit blocks resulting in another candidate set of soft bit blocks; select from the candidate sets of soft bit blocks the candidate set of soft bit blocks that represents the at least part of the data.

Example embodiments provide a method for reception of data in a wireless communication system, the method comprising: determining in accordance with a modulation scheme a candidate set of soft bit blocks representing at least part of the data, the set of soft bit blocks representing a set of constellation points in a modulation constellation of the modulation scheme, wherein an application of each geometric transformation operation of a set of geometric transformation operations to a corresponding subset of the set of constellation points or to the set of constellation points, preserves the shape of the modulation constellation but results data being represented differently; for each geometric transformation operation of the set of geometric transformation operations, modifying according to the geometric transformation operation corresponding soft bit blocks of the candidate set of soft bit blocks resulting in another candidate set of soft bit blocks; selecting from the candidate sets of soft bit blocks the candidate set of soft bit blocks that likely represents the at least part of the data.

### BRIEF DESCRIPTION OF THE DRAWINGS

The accompanying figures are included to provide a further understanding of examples, and are incorporated in and constitute part of this specification. In the figures:
FIG. 1 is a block diagram illustrating an example radio access network in accordance with an example of the present subject matter;
FIG. 2 is a process flowchart illustrating a method for reception of data in a wireless communication system according to an example of the present subject matter;
FIG. 3 is a block diagram illustrating a method for training a machine learning (ML) model in accordance with an example of the present subject matter;
FIG. 4 is a block diagram illustrating components of a ML-based receiver and a method for receiving radio frequency (RF) signals in accordance with an example of the present subject matter;
FIG. 5 is a block diagram illustrating an example of the machine learning model according to an example of the present subject matter;
FIG. 6 is a block diagram illustrating a method for training the machine learning model in accordance with an example of the present subject matter;
FIG. 7A is a diagram illustrating a curriculum-learning-based approach for training by gradually refining the constellation of a modulation scheme in accordance with an example of the present subject matter;
FIG. 7B is a diagram illustrating a training schedule for reducing asymmetry in the constellation over training iterations according to an example of the present subject matter;
FIG. 8 is a plot illustrating the separation between correct and incorrect rotations after a single decoding iteration, plotted with respect to first and second statistical moments according to an example of the present subject matter; and
FIG. 9 is a block diagram illustrating an example apparatus according to the present subject matter.

### DETAILED DESCRIPTION

In the following description, for purposes of explanation and not limitation, specific details are set forth such as particular architectures, interfaces, techniques, etc., in order to provide a thorough understanding of the examples. However, it will be apparent to those skilled in the art that the disclosed subject matter may be practiced in other illustrative examples that depart from these specific details. In some instances, detailed descriptions of well-known devices and/or methods are omitted so as not to obscure the description with unnecessary detail.

Recent advancements in physical layer processing have demonstrated significant performance improvements over conventional receivers, particularly in pilotless signal detection, i.e., detection without the use of or reliance on channel estimation pilot signals. Data-aided detection techniques indicate that leveraging unknown received symbols can enhance accuracy, even in the absence of explicit channel estimation pilots. However, existing pilotless detection methods may rely on specialized or non-standard constellation structures, and no widely adopted approach enables pilotless detection using commonly used modulation schemes.

The present subject matter may enhance signal detection in a wireless communication system by leveraging geometric transformations to generate multiple candidate representations of soft bit blocks while preserving the modulation constellation's shape. By systematically modifying the candidate set based on transformation operations and selecting the most probable representation, the method may improve robustness against distortions, such as phase shifts. The present subject matter may maximize throughput and spectral efficiency while maintaining reliable signal detection by, for example, removing the need for channel estimation pilots. The present subject matter may enable detecting signals without pilots, thereby reducing signaling overhead and improving throughput. The presented methods may thus enable a computationally efficient, power-conscious, and scalable solution for next-generation wireless communication systems.

Generally, an apparatus may be provided for enabling reception of data in the wireless communication system. The apparatus may, for example, be provided as a component of a receiver, wherein the receiver may be part of a node or a device in the wireless communication system. Alternatively, the apparatus may comprise the receiver. The data may, for example, be sent to the apparatus by a set of one or more devices of the wireless communication system. The apparatus may receive the data from the set of one or more devices, with the reception occurring depending on the data size, either entirely within a single time interval or incrementally over multiple time intervals, where each interval comprises a part of the data.

The transmission and reception of data within the wireless communication system may be performed in accordance with a modulation scheme. For example, the apparatus may be configured to transmit and receive in accordance with the modulation scheme. The modulation scheme may involve mapping bits (referred to as mapped bits) of data to symbols in a predefined constellation, where each symbol may represent a unique combination of signal parameters such as amplitude, phase, or frequency. The modulation scheme may have a modulation order defining the number of bits per symbol, so that each symbol corresponds to a specific group of bits according to the constellation mapping. The mapped bits may be obtained from initial bits by applying an error-control encoding process on the initial bits. The error-control encoding process may, for example, introduce structured redundancy to protect data against errors and add verification information to enable the receiver to perform a check to determine whether the received data contains errors. The symbols may undergo a transmission process before being radiated as a radio frequency signal. At the receiver, the reception process may represent the inverse of the transmission process, ensuring that the received radio frequency signal undergoes processing to recover each symbol as a respective soft bit block. The soft bit blocks may represent the mapped bits. Each soft bit block may represent a respective constellation point in the constellation. The soft bit blocks may then be processed using an error-control decoding process . This error-control decoding process may include error correction to recover the original bit sequence and error detection to verify the integrity of the received data.

The present subject matter may use the soft bit blocks, which are an intermediate representation of the received data between the reception process and error-control decoding process. The present subject matter may operate at the level of soft bit block processing, where modifications and selection techniques may be applied to optimize signal detection and improve reception robustness in challenging channel conditions. While the preceding reception process and subsequent error-control decoding process define an example context in which the method may function, the present subject matter is not limited to these specific implementations, allowing flexibility in different system architectures.

The apparatus may be configured to receive at least part of the data in a radio frequency signal and perform on the radio frequency signal the reception process to obtain a candidate set of soft bit blocks representing the at least part of data. The candidate set of soft bit blocks may correspond to a set of constellation points in the modulation constellation of the modulation scheme respectively. For example, a soft bit block may be determined for each constellation point in the set of constellation points. The soft bit block may comprise soft bits that represent a likelihood of each bit in the group of bits being either '0' or '1.' A soft bit may be a representation of a bit, where the soft bit may include information about the confidence in the bit's value, rather than just a hard decision of '0' or '1.' Unlike a (normal) bit, which is strictly binary, a soft bit may, for example, be provided as information, e.g., in the form of a scale, such as from -1 to +1 or 0 to 1, to reflect the likelihood of the bit being a '1' or a '0'. Another example may represent the soft bit with a logarithmic scale, in which case the range of values could be any real number (positive or negative). Such a logarithmic value may be referred to as log-likelihood ratio (LLR). The LLR may be calculated as the logarithm of the ratio of probabilities between the bit being zero or being one. The candidate set of soft bit blocks may be referred to as original candidate set of soft bit blocks.

However, one or more constellation points that represent the initial symbols may be swapped due to effects of the wireless channel during their transmission. The swapping of positions may, for example, refer to exchanging, rearranging, changing, or shifting of the positions. The swapping may be due to several factors, such as phase rotation, which may occur individually or in combination. The swapping operations may be performed such that the same structure or shape of the constellation is maintained or preserved, meaning that while one or more individual symbols change positions, the geometric arrangement of points remains intact. The shape of the constellation may refer to its geometric arrangement, which may be defined by the positions of the constellation points and the relative distances and angles between them. The swapping may alter only a subset of constellation points, for example, when specific points are shifted due to localized distortions or multipath interference. Alternatively, the swapping may involve the entire constellation, such as in cases of uniform phase shifts, where all constellation points move systematically while maintaining the shape of the constellation.

The swapping may be dependent on the underlying cause or mechanism, such as phase-induced effects or an unknown cause, and thus may be classified into different swapping types, such as phase-induced swapping, or adaptive swapping to account for unidentified or dynamically varying factors. Each swapping type may be associated with its underlying cause and may correspond to a group of one or more geometric transformation operations, where each geometric transformation operation may swap either the entire set of constellation points or a subset of the set of constellation points while maintaining the shape of the constellation. For each specific swapping type, each geometric transformation operation within the associated group of one or more geometric transformation operations may be applicable to or associated with specific points in the constellation, where these specific points occupy defined positions within the constellation. These specific points may constitute a subset of two or more points or may encompass the entire set of constellation points. Furthermore, the specific points associated with a particular geometric transformation operation may or may not be the same across different geometric transformation operations within the same swapping type, allowing for variations in how the constellation points are affected while maintaining the overall structure or shape of the constellation. For example, for a phase-induced cause, the group of geometric transformations may comprise one or more rotations, such as one, two, or three rotations, by multiples of 90 degrees (90°), ensuring that all possible phase shifts are accounted for. In contrast, for an unknown cause, the group of geometric transformations may encompass all possible pairwise symbol swaps within the constellation, providing a more generalized approach to symbol realignment. The latter approach may be advantageous in cases where the causes of swapping are unknown or result from a complex combination of factors, making predefined transformation sets insufficient. Additionally, if sufficient computational resources are available, this approach may enable comprehensive handling of all potential symbol exchanges.

In order to improve the efficiency and accuracy of the error-control decoding process for the original candidate set of soft bit blocks, the present subject matter may take into account the swapping by, for example, first determining one or more applicable swapping types and the associated geometric transformation operations. This may allow the error-control decoding process to compensate for symbol misplacements caused by phase shifts or other impairments. For example, the apparatus may be configured to determine a set of geometric transformation operations. The set of geometric transformation operations may comprise one or more geometric transformation operations. The apparatus may be configured to determine the set of geometric transformation operations by receiving signaling that indicates one or more applicable swapping types and corresponding transformation operations. Alternatively, the apparatus may comprise a data structure of entries, each entry comprising a swapping type and an associated group of one or more geometric transformation operations. The apparatus may be configured to select one or more swapping types from the data structure based on a selection criterion, which may be an arbitrary selection or be based on historical data, predefined rules, or adaptive learning mechanisms, allowing the apparatus to optimize transformation selection dynamically. In the case of pilotless detection, the transformation may be selected such that any ambiguities regarding the correct phase rotation may be resolved. The set of geometric transformation operations may be the ones associated with the selected swapping type(s).

For each geometric transformation operation of the set of geometric transformation operations, the apparatus may be configured to modify, according to one or more predefined actions associated with the geometric transformation operation, corresponding soft bit blocks of the original candidate set of soft bit blocks to generate another candidate set of soft bit blocks. The soft bit block in the original candidate set of the bit blocks is associated with a respective point in the constellation, and, if the geometric transformation operation is applied to the respective constellation point causing the respective constellation point to have a new position, the soft bit block values may be modified to reflect the new position of the respective constellation point. This modification may ensure that the soft bit block representation remains aligned with the transformed position of the respective constellation point. However, depending on the geometric transformation, the modification may be applied to a subset of the soft bit blocks or to the entire original candidate set of soft bit blocks. In any case, this may result in a new candidate set of soft bit blocks, where either all soft bit blocks are modified from the original candidate set or only a portion of them is altered.

Hence, in addition to the original candidate set of soft bit blocks, one additional candidate set of soft bit blocks may be provided per geometric transformation operation in the set of geometric transformation operations. Each additional candidate set corresponds to a modified version of the original set of soft bit blocks, reflecting the effect of the respective geometric transformation on the constellation points. These may be referred to as sets of candidate soft bit blocks, which include a number of candidate sets equal to the number of geometric transformation operations in the set of geometric transformation operations plus one representing the original candidate set of soft bit blocks. Each candidate set corresponds to either the original soft bit blocks or a transformed version resulting from the application of a specific geometric transformation operation.

The apparatus may be configured to select from the candidate sets of soft bit blocks the candidate set of soft bit blocks that represents the at least part of the data. The selection may be performed by executing the error-control decoding process or without executing the error-control decoding process. In the first case, the selection may, for example, be based on error correction decoding performance, choosing the candidate set that results in the most reliable or error-free decoded output. In the first case, the selection may be performed by executing fully or partially the error-control decoding process on each candidate set of soft bit blocks to assess its decoding reliability. In the latter case, the selection may, for example, be based on the statistical properties of the soft bits, to estimate the most probable candidate set without performing full error-control decoding.

With the present subject matter, the reception process may not require pilot data in the received radio frequency signal in order to decode it. Hence, the received radio frequency signal may not comprise pilot symbols, reducing overhead and improving spectral efficiency. The pilot symbols may, for example, refer to a demodulation reference signal (DMRS) or other types of pilot signals. Alternatively, although the pilot data may not be used for the reception process, the received radio frequency signal may still comprise a small number of pilot symbols for other purposes, such as channel estimation, synchronization, or signal quality monitoring. For example, the number of pilot symbols may be smaller than a threshold. This may ensure compatibility with conventional communication systems while allowing the present subject matter to operate without reliance on pilot-based corrections for symbol alignment.

The present subject matter may use different implementation variants of the reception process that result in the original candidate set of soft bit blocks. These implementations may vary based on factors such as receiver architecture, signal processing techniques, or decoding strategies, allowing for flexibility in how the original candidate set is obtained. According to one example, the apparatus may be configured to determine the original candidate set of soft bit blocks by at least: receive the radio frequency signal comprising the at least part of the data, and process the radio frequency signal in accordance with the modulation scheme to obtain the original candidate set of soft bit blocks, wherein the radio frequency signal is pilotless excluding reference signal data. According to one example, the apparatus may be configured to determine the original candidate set of soft bit blocks by at least: receive the radio frequency signal comprising the at least part of the data, process the radio frequency signal to obtain a set of initial modulation symbols, input the set of initial modulation symbols to a machine learning model to obtain the original candidate set of soft bit blocks.

In one example, the machine learning model may further be configured to: for each geometric transformation operation of the set of geometric transformation operations, modify according to the geometric transformation operation corresponding soft bit blocks of the candidate set of soft bit blocks generating another candidate set of soft bit blocks, and select from the candidate sets of soft bit blocks the candidate set of soft bit blocks that represents the at least part of the data. Each of these two operations, modification and selection, may or may not be associated with learnable parameters, such as transformation weights or confidence metrics, which may be learned during training of the machine learning model. The machine learning model in this case may be referred to as DeepRxPilotless model.

For example, the reception process may involve a given component that generates the original candidate set of soft bit blocks from a set of initial modulation symbols. The given component may be referred to as a frequency-domain samples processing component. In one example, the frequency-domain samples processing component may apply the machine learning model (e.g., a deep neural network) to the set of initial modulation symbols to generate the original candidate set of soft bit blocks. However, these are only two possible examples, and the present subject matter is not limited to these configurations; other approaches may also be employed within the scope of the frequency-domain samples processing component.

According to one example, the apparatus may be configured to select the candidate set of soft bit blocks by at least: process the candidate sets of soft bit blocks with a decoding process followed by an error detection process, and selecting the candidate set of soft bit blocks that passed the error detection process. The decoding process and the error detection process may, for example, form the error-control decoding process.

Indeed, the apparatus may determine the correct candidate set of soft bit blocks by employing a decoding process followed by an error detection process, ensuring that only a valid candidate set is selected. In this context, decoding may refer to the process of reconstructing the transmitted bit sequence from received noisy soft bit representations, while error detection refers to verifying whether the decoded sequence contains errors. The error-control decoding process may encompass both the decoding and error detection steps. The advantage of this approach may be that it may allow the apparatus to systematically evaluate multiple candidate sets of soft bit blocks and select the one that leads to an error-free or most reliable (one having smallest error) decoded output, thereby improving robustness against symbol swapping, misalignment, or transmission distortions. According to one example, the decoding process is a low-density parity check (LDPC) decoding and the error detection processing is a cyclic redundancy check (CRC).

In this example, the decoding process is implemented as LDPC decoding, a forward error correction (FEC) technique that may efficiently correct transmission errors by leveraging a sparse parity-check matrix. The error detection process may be implemented using the CRC, which may verify the integrity of the decoded bits by computing and comparing a checksum. The advantage of combining LDPC and CRC may be that LDPC may provide strong error correction, while CRC may act as a final verification step, ensuring that only correctly decoded (an error-free or most reliable, such as one having smallest error) data is selected.

According to one example (first LDPC based selection example), the LDPC decoding is performed for each candidate set of soft bit blocks of the candidate sets of soft bit blocks to obtain a set of decoded bits per candidate set of soft bit blocks, before applying the CRC check on the sets of decoded bits. To ensure that all potential symbol mappings are considered, the LDPC decoding is performed separately for each candidate set of soft bit blocks, producing a corresponding set of decoded bits per candidate set. Once the LDPC decoding is complete, a CRC check is applied to each set of decoded bits to determine its validity. According to one example (second LDPC based selection example), the apparatus may be configured to select the candidate set of soft bit blocks by at least: perform a first iteration of a low-density parity check, LDPC, decoding for each candidate set of soft bit blocks of the candidate sets of soft bit blocks to obtain an intermediate set of decoded bits per candidate set of soft bit blocks, select one intermediate set of decoded bits based on a statistical property of the intermediate sets of decoded bits; and complete the LDPC decoding on the selected intermediate set of decoded bits to obtain a set of decoded bits, wherein the selected candidate set of soft bit blocks is the candidate set of soft bit blocks associated with the selected intermediate set of decoded bits.

LDPC decoding is an error correction technique that iteratively refines bit estimates using a sparse parity-check matrix, meaning that LDPC decoding inherently comprises multiple iterations to gradually improve decoding accuracy. The apparatus may optimize the selection of the candidate set of soft bit blocks by employing a multi-stage LDPC decoding process that leverages statistical properties to enhance efficiency. In this approach, an initial iteration of LDPC decoding is performed for each candidate set of soft bit blocks, yielding an intermediate set of decoded bits per candidate set of soft bit blocks. A statistical property, such as bit reliability or convergence metrics, may then be evaluated across all intermediate sets of decoded bits to identify the most promising candidate for further processing. The final LDPC decoding is then completed only for the selected intermediate set of decoded bits. Statistical selection may enable early rejection of unlikely candidates, minimizing unnecessary processing overhead.

According to one example (third LDPC based selection example), the apparatus may be configured to select the candidate set of soft bit blocks by at least: repeatedly: perform a current iteration of an LDPC decoding for each candidate set of soft bit blocks of the candidate sets of soft bit blocks to obtain an intermediate set of decoded bits per candidate set of soft bit blocks; and select one intermediate set of decoded bits based on a statistical property of the intermediate sets of decoded bits; wherein the repetition is performed until the intermediate set of decoded bits is selected; and complete the LDPC decoding on the selected intermediate set of decoded bits to obtain a set of decoded bits, wherein the selected candidate set of soft bit blocks is the candidate set of soft bit blocks associated with the selected intermediate set of decoded bits.

The apparatus may optimize the selection of the candidate set of soft bit blocks by employing the LDPC decoding process combined with statistical selection to enhance efficiency. In this approach, the apparatus performs LDPC decoding iteratively for each candidate set of soft bit blocks, generating an intermediate set of decoded bits per iteration. After each iteration, the statistical property is evaluated across all intermediate sets of decoded bits to identify the most promising candidate. This process is repeated until an intermediate set of decoded bits is selected, at which point the apparatus completes LDPC decoding only for that selected candidate set of soft bit blocks, obtaining the final decoded output. Compared to prior selection alternatives, which relied on a single LDPC iteration before selection or a fixed number of iterations, this repetitive selection approach may dynamically adapt the number of iterations based on statistical properties, ensuring an optimal balance between computational complexity and decoding reliability.

This example may make the number of iterations of the LDPC decoding dependent on the selection of the intermediate set of decoded bits, allowing for adaptive iteration control based on decoding progress. If the selection is successfully performed before reaching the last iteration, the apparatus may complete the LDPC decoding only for the selected intermediate set, skipping further iterations for the other candidate sets..

According to one example, the apparatus may be configured to select the intermediate set of decoded bits by at least one of: calculating an average magnitude, representing the statistical property, of each intermediate set of decoded bits and selecting the intermediate set of decoded bits that has the largest average magnitude; or calculating predefined moments, representing the statistical property, from the intermediate sets of decoded bits and inputting the moments to a neural network, which has been trained to select a correct intermediate set of decoded bits based on the input.

The apparatus may optimize the selection of the intermediate set of decoded bits by leveraging statistical metrics or machine learning-based selection to improve decoding reliability and efficiency. An intermediate set of decoded bits represents a partially decoded output obtained during iterative LDPC decoding, which is used for candidate selection before completing the final iteration of the decoding process. In one approach, the apparatus may calculate the average magnitude of the decoded bit values, where larger magnitudes indicate stronger confidence levels, and select the intermediate set with the largest average magnitude. Alternatively, the apparatus may compute predefined statistical moments (e.g., mean, variance, and skewness) from the intermediate sets of decoded bits and input them into a neural network trained to recognize correct intermediate sets. The use of neural networks may enable the apparatus to learn complex selection patterns beyond simple magnitude-based heuristics, improving selection accuracy in challenging channel conditions. According to one example, the machine learning model is a convolutional neural network comprising multiple convolutional layers, where the convolutional layers implement one-dimensional filters, alternating between dimensions corresponding to a frequency domain and a time domain of the at least part of the data.

The convolutional neural network (CNN) is a deep learning architecture that applies convolutional layers to extract and process relevant features from input data. In this example, the CNN comprises multiple convolutional layers, each utilizing one-dimensional filters that operate alternately along two distinct dimensions: the frequency domain and the time domain of at least part of the data. In the frequency domain, convolutional filters analyze spectral characteristics, e.g., detecting frequency-dependent distortions that could impact decoding accuracy. In the time domain, convolutional filters capture temporal dependencies, such as symbol transitions which may be critical for identifying the correct intermediate set of decoded bits. By alternating between these domains, the CNN may effectively learn both spectral and temporal relationships, allowing it to generalize across different channel conditions and impairments.

According to one example, the apparatus may be configured to process the selected candidate set of soft bit blocks using the error-control decoding process to recover the at least part of data which is received in the radio frequency signal. This may be performed if the selection process did not already include decoding as part of the selection criteria. In such cases, the error-control decoding process may ensure that the selected candidate set is fully processed to recover the transmitted data. This approach may allow for flexible integration of selection and decoding, optimizing computational efficiency while maintaining reliable data reception.

According to one example, an operation (named soft bit processing operation) comprises operation of the determining of the candidate set of soft bit blocks and operation of the modifying of the method, wherein the apparatus may be configured to train the machine learning model by at least: perform the soft bit processing operation on a training radio frequency signal to obtain training candidate sets of soft bit blocks, evaluate for each training candidate set of the soft bit blocks of the training candidate sets of soft bit blocks a loss function, resulting in multiple values of the loss function, and use the smallest value of the multiple values for updating the machine learning model and repeat the training or provide the machine learning model.

In this approach, the machine learning model is trained using an iterative process that may ensure it accurately maps received signals to candidate soft-bit values while accounting for distortions. The soft bit processing operation may involve two stages: (1) determining the training candidate set of soft bit blocks from the training radio frequency signal and (2) modifying the training candidate set based on geometric transformations. To train the machine learning model, in each training step the apparatus performs this soft bit processing operation on a training radio frequency signal, obtaining training candidate sets of soft bit blocks. Each training candidate set is then evaluated using a loss function, which may quantify how well the soft-bit values align with the expected correct values. This evaluation produces multiple loss function values, corresponding to different training candidate sets. The smallest loss function value may be selected as the most optimal representation, and the machine learning model is updated accordingly. In the case of quadrature amplitude modulation (QAM) data, it is likely that the smallest loss function corresponds to the correct phase orientation of the received signal among four different alternatives, each with a multiple of 90 degree phase offset. The training may be conducted using stochastic gradient descent (SGD) for updating the machine learning model' parameters iteratively to minimize a loss function. The loss function may, for example, comprise a mean squared error (MSE) or cross-entropy loss function. This training process is then repeated iteratively until a convergence criterion is fulfilled. The convergence criterion may, for example, require that the loss function value reaches a predefined threshold, indicating that further training does not significantly improve performance. Alternatively, convergence may be determined based on stability in loss reduction over consecutive iterations. Other possible criteria may include achieving a maximum number of iterations or a minimum error rate.

The machine learning model may be trained using a training dataset, which comprises entries, where each entry represents a training radio frequency signal. Each entry may include a label corresponding to the data embedded in the training radio frequency signal, allowing the model to learn the correct associations. Additionally, the entry may comprise either the training radio frequency signal itself in sample form or a training set of initial modulation symbols, which are obtained by performing the reception process on the training radio frequency signal.

According to one example, the training is performed using a training dataset comprising entries, each entry represents a training set of initial modulation symbols in accordance with the modulation scheme obtained from the training radio frequency signal, wherein the entries represent different shapes of the modulation constellation, wherein the shapes have an asymmetry that is progressively reduced during the training until the shape of the modulation constellation becomes a regular shape of the modulation scheme.

The entries of the training dataset may be split into subsets, each defining a progressive refinement of constellation structures. Each subset may be associated with a respective shape of the constellation. The first subset may consist of a highly asymmetric constellation, making detection easier due to having no phase ambiguity. This may help the machine learning model to start learning the reception task. As training iterations progress, the asymmetry in the constellations is gradually reduced, transitioning through intermediate subsets with progressively more symmetric constellation structures. The last subset represents a fully symmetric constellation, ensuring that by the final stages of training, the machine learning model has learned to accurately interpret standard modulation schemes. At each progress level, the machine learning model may be trained on the corresponding subset of entries.

The advantage of this approach may be that it may allow the machine learning model to learn more easily in the beginning of the training procedure. The use of more asymmetric constellations in the beginning may allow the machine learning model to detect the correct soft bits without any phase ambiguity. After the machine learning model has started the learning, the asymmetry of the constellation may be gradually removed to end up with the standard symmetric constellation. This approach may be referred to as curriculum-learning-based approach. In an alternative example, the training of the machine learning model may be performed by another apparatus and the resulting trained machine learning model may be received by the apparatus. According to one example, the modulation scheme being a QAM. Data may be transmitted using symbols that represent combinations of amplitude and phase in a predefined constellation grid. QAM may enable efficient data transmission by mapping multiple bits per symbol, with the modulation order determining the number of bits represented per symbol.

According to one example, the set of geometric transformation operations are rotation operations. In this example, the swapping type may be phase-induced swapping. In this scenario, the received radio frequency signal may be subject to a phase shift, affecting all modulation symbols in the constellation. A constant phase shift may occur so the received signal undergoes a uniform phase rotation, leading to a rotation of the entire constellation by a fixed angle θ without altering its shape. For QAM modulation, the fixed rotation angles may be typically 90°, 180°, and 270°, or equivalently -90°, 90°, and 180°. The reason for these specific angles may be that QAM constellations are typically symmetric with respect to the origin, meaning that a phase shift of ±90°, 180°, or 270° may result in a different but structurally identical constellation mapping. There are only three rotation angles (90°, 180°, and 270°) rather than four because a 360° (or 0°) rotation may represent the constellation representing the original candidate set of soft bit blocks, meaning its application would return the constellation to its initial orientation, making it redundant.

In this example, each soft bit block of the candidate set of soft bit blocks may comprise a block of LLRs and thus be referred to as LLR-block, resulting in a candidate set of LLR-blocks. The modification of each LLR-block in accordance with each rotation operation of the set of rotation operations may be performed as follows. The set of LLR-blocks may be manipulated to produce corresponding three sets of LLR-blocks, or one set for each of the three 90-degree rotations. Denoting the LLR-block of an individual resource element corresponding to the i-th subcarrier and *j*-th OFDM symbol by vector ${l}_{ij} ∈ {ℝ}^{{Q}_{m}}$, where *Qₘ* is the number of bits per symbol, one modification method for obtaining the rotations may be as follows: ${l}_{ij}^{R} = sign \left({s}_{c , R}⊙{l}_{ij}\right) ⊙ \left|{B}_{R}{l}_{ij}\right|$ , where ${s}_{c , R} ∈ {ℝ}^{{Q}_{m}}$ is a vector consisting of values in the set of {-1,1} corresponding to rotation *R*∈{-90,90,180} and symbol *c*, which represents the hard symbol decision of ***l**ᵢⱼ, **s**_{c,R}* determines how the signs of the LLRs in the LLR-block should be flipped to achieve each rotation, ⊙ denotes the Hadamard product, i.e., element-wise product between two matrices or vectors, *sign*(·) denotes the sign function, and ${B}_{R} ∈ {ℝ}^{{Q}_{m} \times {Q}_{m}}$ is a square matrix consisting of values in the set of {0,1} corresponding to rotation *R∈*{-90,90,180}. This matrix may rearrange the LLR values to achieve the desired rotation.

The obtained three additional candidate sets of LLR-blocks, taken together with the original candidate set, mean that there are, in total, four alternative sets of LLR-blocks for each resource element, denoted by ${l}_{ij}^{R}$, where *R∈*{0, -90,90,180} is the rotation in degrees. In one example, each of these four sets of LLR-blocks is fed to an LDPC decoder. Then, the CRC checks of all four LDPC outputs are considered and the one whose CRC is zero is forwarded to protocol Layer 2 (L2) as the correct set of bits. In case none of the CRCs pass, a CRC failure is indicated to L2 and hybrid automatic repeat request (HARQ) retransmission is initiated. In an alternative example, the four sets of LLR-blocks are fed to an LDPC decoder that only computes one (e.g., first) iteration. After the first iteration, the four sets of LLR-blocks are compared and only one of the four is fed to a full LDPC decoder that computes all the iterations. The decision regarding which of the four sets of LLR-blocks to feed to the full LDPC decoder may be based on one of the following: calculating the average magnitude of each set of LLR-blocks and choosing the set of LLR-blocks that has the largest value or calculating a predefined set of moments from the four sets of LLR-blocks and feeding these statistics to a neural network, which has been trained to output the correct rotation (set of LLR-blocks) based on that information. In another example, the four sets of LLR-blocks are calculated for as many LDPC iterations as it takes for there to emerge a rotation (set of LLR-blocks) that has a sufficiently high likelihood (e.g., likelihood greater than a threshold) of being the correct one. This may mean that after each LDPC iteration, a predefined statistic is calculated for all four sets of LLR-blocks, e.g., one of the moments or the average magnitude. Then, a difference matrix is computed among all the four candidate sets and if one of the candidate sets has a significantly higher (e.g., largest or larger than a threshold) value of the likelihood metric than others, it is chosen as the correct candidate set and the corresponding set of LLR-blocks are fed to a complete LDPC decoder.

Example values of the vector ***s**_{c,R}* may be provided as follows. For 16-QAM modulation, symbol mappings under different rotations may exhibit distinct transformations while preserving the relative constellation structure. When a -90° rotation is applied, the vector ***s***_{*c*,-90}, with the symbol c written in decimal (0-15), may have the following values: **s**_{0,-90} = [1, -1, 1, 1], **s**_{1,-90} = [1, -1, -1, -1], **s**_{2,-90} = [1, -1, -1, -1], **s**_{3,-90} = -1, 1, 11, **s**_{4,-90} = [-1,1,1,1], **s**_{5,-90} = [-1,1,-1,-1], **s**_{6,-90} = [-1, 1, -1, -1], **s**_{7,-90} = [-1, 1, 1, 1], **s**_{8,-90} = [-1, 1, 1, 1], **s**_{9,-90} = [-1, 1, -1, -1], **s**_{10,-90} = [-1, 1, -1, -1], **s**_{11,-90} = [-1,1,1,1], **s**_{12,-90} = [1,-1,1,1], **s**_{13,-90} = [1, -1, -1, -1], **s**_{14,-90} = [1, -1, -1, -1], **s**_{15,-90} = [1, -1, 1, 1], while the bit representation maintains a structured format reflecting this rotation as follows: ${B}_{- 90} = \left[\begin{matrix}0 & 1 & 0 & 0 \\ 1 & 0 & 0 & 0 \\ 0 & 0 & 0 & 1 \\ 0 & 0 & 1 & 0\end{matrix}\right]$. Similarly, under a 90° rotation, the vector ***s***_{*c*,90} may exhibit an inverse transformation compared to -90°, leading to values such as **s**_{0,90} = [-1, 1, 1, 1], **s**_{1,90} = [-1, 1, -1, -11, **s**_{2,90} = [-1, 1, -1, -1], **s**_{3,90} = [-1, 1, 1, 1], **s**_{4,90} = [1,-1,1,1], **s**_{5,90} = [1, -1, -1, -1], **s**_{6,90} = [1, -1, -1, -1], **s**_{7,90} = [1, -1, 1, 1], **s**_{8,90} = [1, -1, 1, 1], **s**_{9,90} = [1, -1, -1, -1], **s**_{10,90} = [1, -1, -1, -1], **s**_{11,90} = [1, -1, 1, 1], **s**_{12,90} = [-1, 1, 1, 1], **s**_{13,90} = [-1, 1, -1, -1], **s**_{14,90} = [-1, 1, -1, -1], **s**_{15,90} = [-1, 1, 1, 1], with the corresponding bit structure retaining symmetry with respect to the original constellation as follows: ${B}_{90} = \left[\begin{matrix}0 & 1 & 0 & 0 \\ 1 & 0 & 0 & 0 \\ 0 & 0 & 0 & 1 \\ 0 & 0 & 1 & 0\end{matrix}\right]$. When a 180° rotation is applied, the vector ***s***_{*c*,180} may have the values: **s**_{0,130} = [-1, -1, 1, 1], **s**_{1,180} = [-1, -1, 1, 1], **s**_{2,180} = [-1, -1, 1, 1], **s**_{3,180} = [-1, -1, 1, 1], **s**_{4,180} = [-1, -1, 1, 1], **s**_{5,180} = [-1, -1, 1, 1], **s**_{6,180} = [-1, -1, 1, 1], **s**_{7,180} = [-1, -1, 1, 1], **s**_{8,180} = [-1, -1, 1, 1], **s**_{9,180} = [-1, -1, 1, 1], **s**_{10,180} = [-1, -1, 1, 1], **s**_{11,180} = [-1, -1, 1, 1], **s**_{12,180} = [-1, -1, 1, 1], **s**_{13,180} = [-1, -1, 1, 1], **s**_{14,180} = [-1, -1, 1, 1], **s**_{15,180} = [-1, -1, 1, 1], and the bit representation reflecting this inversion may be provided as follows: ${B}_{180} = \left[\begin{matrix}1 & 0 & 0 & 0 \\ 0 & 1 & 0 & 0 \\ 0 & 0 & 1 & 0 \\ 0 & 0 & 0 & 1\end{matrix}\right]$.

According to one example, the at least part of the data is received in a specific time window, the time window being one or more orthogonal frequency division multiplexing (OFDM) symbols, or a transmission time interval (TTI).

In one example implementation, the machine learning model may be DeepRx which is adapted for pilotless data (DeepRxPilotless model), enabling signal detection without the need for pilot symbols. The modulation scheme may be QAM, and the set of geometric transformation operations may consist of rotation operations, which account for possible phase shifts in the received radio frequency signal. The output of DeepRx may be a candidate set of soft bit blocks, where each soft bit block comprises an LLR-block, representing soft-decision metrics for bit probabilities. The size of each soft bit block corresponds to the order of the QAM modulation. The inference and the training may be performed as follows. In the inference phase, the DeepRx outputs LLRs, which corresponds to producing the LLRs for all three multiples of 90-degree phase rotation (e.g., 90°, 180°, and 270°), by manipulating the output LLRs of DeepRx in a predefined manner (noting that DeepRx may, for example, output one of these rotations, which could have a phase offset of 90, 180, or 270 degrees); and running parallel LDPC decoders for all these rotations and checking which of the four options returns a CRC pass, with the correct rotation being determined and the decoded bits from this LDPC decoder forwarded to L2. This inference may enable a machine learning-based scheme for detecting QAM OFDM signals without requiring pilot symbols. Additionally, to address computational complexity and power consumption, more lightweight inference options may be provided, optimizing processing efficiency. One example may be to run four parallel LDPC decoders, but it may be possible to determine the correct rotation based on a small number of LDPC iterations, after which the full number of iterations is only executed for the correct rotation. This may ensure that the number of additional LDPC iterations required by the pilotless operation remains small. In one example, one LDPC iteration is performed for each of the four rotations, and the correct one is determined based on the statistics of the output LLRs from the LDPC iterations. In one example, the number of LDPC iterations before identifying the correct orientation is determined by observing the difference in the statistics of the four sets of LLRs and continuing the iterations until the correct rotation can be reliably established. The training of the machine learning model may be performed such that the training loss is modified in a way that only the rotation that gives the best results (lowest loss) is used in the backwards computation of the SGD training. In order to train the DeepRx to predict accurate LLRs in the first place, a curriculum-learning-based approach may be used. In the present approach the training starts with an asymmetric constellation, which the DeepRx can learn to detect rather easily. However, after the initial phase, the asymmetry of the constellation is slowly reduced until the constellation becomes a regular QAM constellation. This was observed to result in a more accurate receiver model. The training of the machine learning model may be designed such that the training loss is modified to ensure that only the rotation yielding the best results (lowest loss) contributes to the backward computation during stochastic gradient descent (SGD) training. This selective gradient update mechanism may ensure that the model converges toward optimal LLR prediction by reinforcing the most reliable rotation outputs.

In one example implementation, the set of initial modulation symbols may be obtained as follows. Upon receiving the radio frequency signal, the corresponding baseband signal may be obtained and then sampled within a specific time window, resulting in a set of time-domain samples specific to that time window. The time window may comprise one or more transmission units. The transmission unit may, for example, represent an OFDM symbol. The time window may, for example, be a TTI. The set of time-domain samples may then be converted into a set of frequency-domain samples representing a set of frequency units respectively, and with each frequency-domain sample representing an individual modulation symbol. The set of frequency units may, for example, be subcarriers or resource block groups (RBGs). The set of frequency-domain samples for the time window may, for example, be the set of initial modulation symbols respectively. The size of the set of initial modulation symbols may, for example, be equal to the number of subcarriers multiplied by the number of transmission units within the time window. Depending on the modulation scheme, each modulation symbol of the set of initial modulation symbols may represent a block of bits (e.g., 4 or 6 bits). In cases where the received radio frequency signal is encoded using a multiple input multiple output (MIMO) technique, each frequency unit within the set of frequency units may simultaneously be used by one or more data streams. For example, each initial modulation symbol may consist of a superposition of individual initial modulation symbols, either representing multiple transmitters or representing multiple streams from the same transmitter. In this case, the set of initial modulation symbols may represent a (larger) set of individual initial modulation symbols. This may imply that each initial modulation symbol can encode multiple blocks of bits.

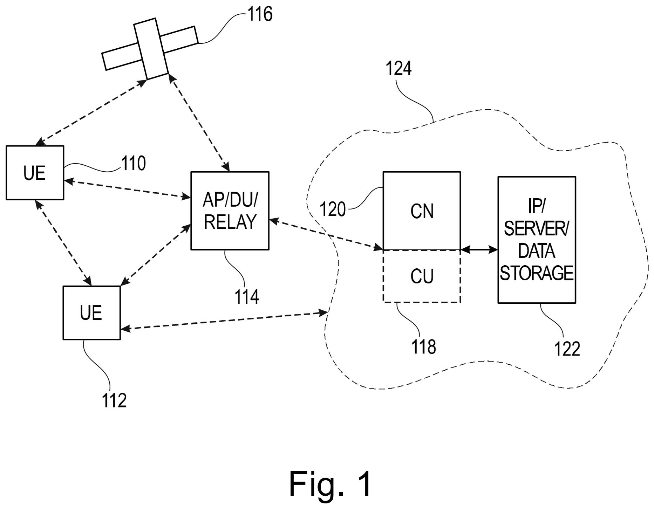

**FIG. 1** is a block diagram illustrating an example radio access network in accordance with an example of the present subject matter. FIG. 1 illustrates examples of simplified system architectures only showing some elements and functional entities, all being logical units, whose implementation may differ from what is shown. The connections illustrated in FIG.1 are logical connections; the actual physical connections may be different. It is apparent to a person skilled in the art that the system typically comprises also other functions and structures than those illustrated in FIG.1. The embodiments are not, however, restricted to the system given as an example but a person skilled in the art may apply the solution to other communication systems provided with necessary properties.

The example radio access network illustrated in FIG.1 includes devices 110 and 112. The devices 110 and 112 may, for example, be user devices. The devices 110 and 112 are configured to be in a wireless connection on one or more communication channels with a node 114. The node 114 is further connected to a core network 120. In one example, the node 114 may be an access node (such as (e/g)NodeB) 114 providing or serving devices in a cell. In one example, the node 114 may be a non-3GPP access node. The physical link from a device to the node 114 is called uplink or reverse link and the physical link from the node 114 to the device is called downlink or forward link. It should be appreciated that (e/g)NodeBs or their functionalities may be implemented by using any node, host, server or access point etc. entity suitable for such a usage.

A communications system typically comprises more than one node 114 in which case the node 114 may also be configured to communicate, via signalling, with one another over links, wired or wireless, designed for the purpose. The node 114 may also be referred to as a base station, an access point or any other type of interfacing device including a relay station capable of operating in a wireless environment. The node 114 includes or is coupled to transceivers. From the transceivers of the node 114, a connection is provided to an antenna unit that establishes bi-directional radio links to devices. The antenna unit may comprise a plurality of antennas or antenna elements. The node 114 is further connected to the core network 120 (CN or next generation core NGC). The device (also called user device, UE, user equipment, user terminal, terminal device, etc.) illustrates one type of an apparatus to which resources on the air interface are allocated and assigned, and thus any feature described herein with a device may be implemented with a corresponding apparatus, such as a relay node. An example of such a relay node is a layer-3 relay (self-backhauling relay) towards the base station.

The device typically refers to a device (e.g., a portable or non-portable computing device) that includes wireless mobile communication devices operating with or without a subscriber identification module (SIM), including, but not limited to, the following types of devices: a mobile station (mobile phone), smartphone, personal digital assistant (PDA), handset, device using a wireless modem (alarm or measurement device, etc.), laptop and/or touch screen computer, tablet, game console, notebook, and multimedia device. It should be appreciated that a device may also be a nearly exclusive uplink only device, of which an example is a camera or video camera loading images or video clips to a network. A device may also be a device having capability to operate in loT network which is a scenario in which objects are provided with the ability to transfer data over a network without requiring human-to-human or human-to-computer interaction, e.g., to be used in smart power grids and connected vehicles.

The communication system is also able to communicate with other networks, such as a public switched telephone network or the Internet as illustrated by the component referenced by reference numeral 122, or utilize services provided by them. The communication network may also be able to support the usage of cloud services, for example at least part of core network operations may be carried out as a cloud 124 service. Application of cloudRAN architecture enables RAN real time functions being carried out at the RAN side (in a distributed unit (DU)) and non-real time functions being carried out in a centralized manner (in a centralized unit, CU 118).

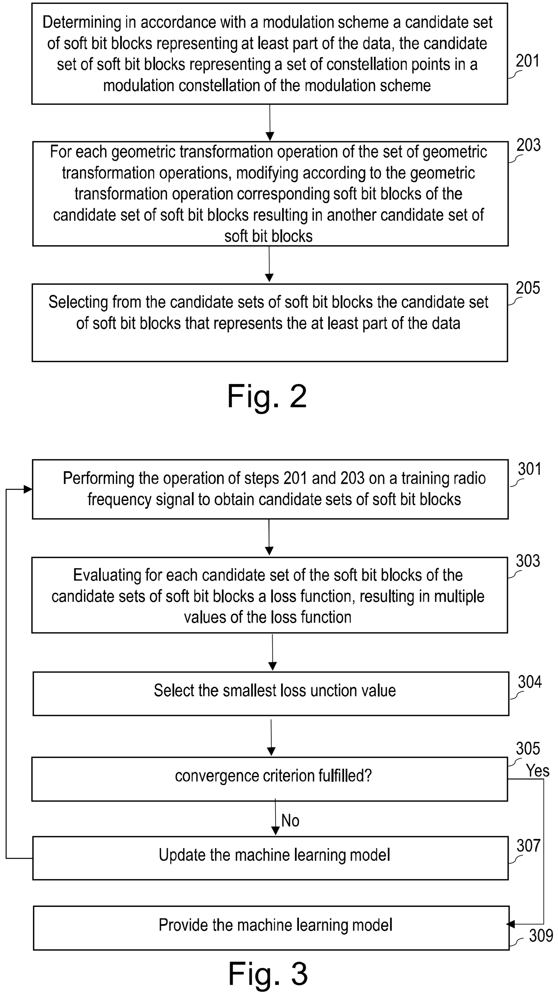

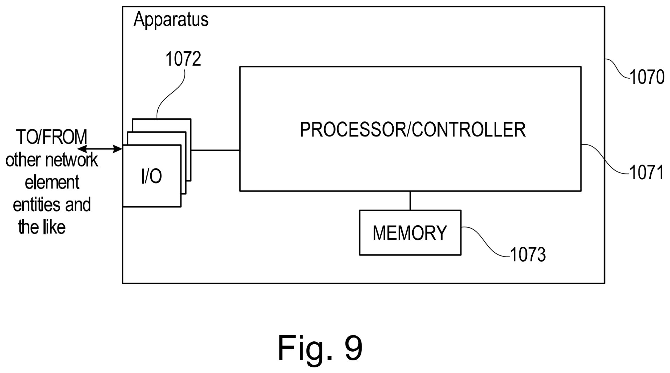

**FIG. 2** is a process flowchart illustrating a method according to an example of the present subject matter. For the purpose of explanation, the method described in reference to FIG. 2 may be implemented in an apparatus such as the node 114 illustrated and described in reference to FIG. 1 or apparatus illustrated and described in reference to FIG. 9 but is not limited to this implementation.

At block 201, one may determine in accordance with a modulation scheme a candidate set of soft bit blocks representing at least part of the data, the candidate set of soft bit blocks representing a set of constellation points in a modulation constellation of the modulation scheme, wherein an application of each geometric transformation operation of a set of geometric transformation operations to a corresponding subset of the set of constellation points or to the set of constellation points preserves the shape of the modulation constellation but results in data being represented differently. For example, the application of each geometric transformation operation of the set of geometric transformation operations to the corresponding subset of the set of constellation points or to the set of constellation points preserves the shape of the modulation constellation but results in representing different data.

At block 203, for each geometric transformation operation of the set of geometric transformation operations, modify according to the geometric transformation operation corresponding soft bit blocks of the candidate set of soft bit blocks resulting in another candidate set of soft bit blocks. At block 205, the candidate set of soft bit blocks that represents the at least part of the data may be selected from the candidate sets of soft bit blocks. The operations of blocks 201 and 203 may, for example, represent the soft bit processing operation which may be applied per radio frequency signal, e.g., using as input a set of initial modulation symbols of the radio frequency signal.

**FIG. 3** is a block diagram illustrating a method to allocate time and frequency resources for a radio frequency signal in accordance with an example of the present subject matter. The radio frequency signal may comprise a first radio frequency signal and a second radio frequency signal. For the purpose of explanation, the method described in reference to FIG. 3 may be implemented in an apparatus such as the node 114 illustrated and described in reference to FIG. 1 or apparatus illustrated and described in reference to FIG. 9 but is not limited to this implementation.

At block 301, the operation of blocks 201 and 203 may be performed on a training radio frequency signal to obtain candidate sets of soft bit blocks. A loss function may be evaluated in block 303 for each candidate set of the soft bit blocks of the candidate sets of soft bit blocks a loss function, resulting in multiple values of the loss function. A lowest value of the multiple values may be selected in block 304. It may be determined in block 305 whether a convergence criterion is fulfilled. If the convergence criterion is not fulfilled, the machine learning model may be updated in block 307 and the training may be repeated using another training radio frequency signal by going back to block 301. The update may, for example, be performed using the selected lowest value of the values of the loss function. If the convergence criterion is fulfilled, the machine learning model may be provided in block 309. The convergence criterion may be the reaching of a predefined number of iterations.

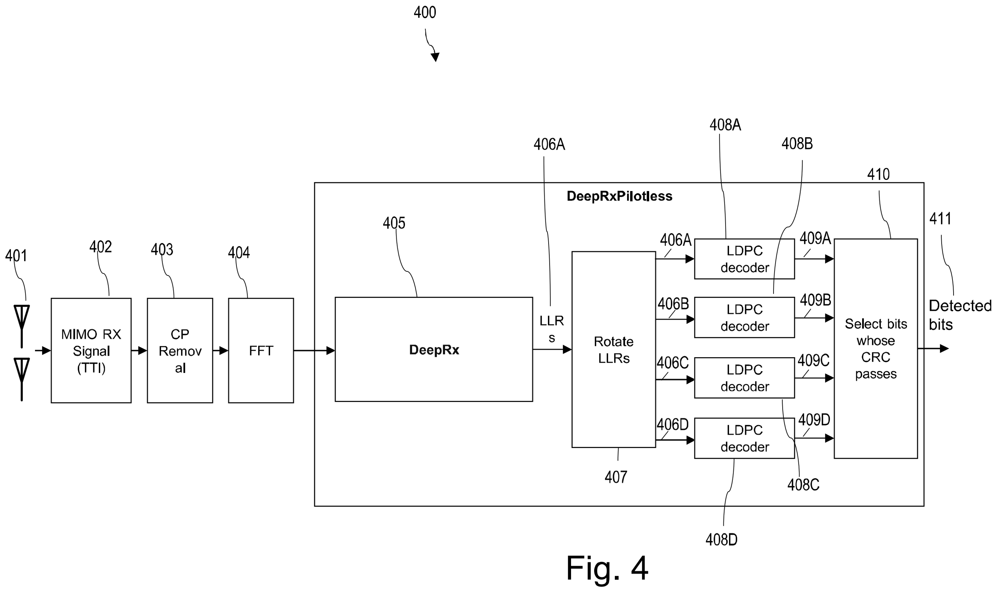

**FIG. 4** is a block diagram illustrating components of a ML-based receiver and a method for receiving radio frequency signals in accordance with an example of the present subject matter. The receiver 400 comprises an antenna system 401, configured to receive a radio frequency signal. The received radio frequency signal may be converted into raw received data organized per TTI in block 402. This data undergoes cyclic prefix (CP) removal in block 403, followed by a Fast Fourier Transform (FFT) in block 404, which prepares the data in the frequency domain as a set of initial modulation symbols. The set of initial modulation symbols is then fed into a deep learning receiver (DeepRx) in block 405, which produces an original candidate set of LLR-blocks 406A for the set of initial modulation symbols respectively. The original candidate set of LLR-blocks 406A is modified in block 407 by the three rotation operations, 90, 180 and 270 degrees to obtain three additional candidate sets of LLR-blocks 406B, 406C, and 406D. The four candidate sets of LLR-blocks 406A, 406B, 406C, and 406D may be processed by the respective LDPC decoders 408A through 408D to obtain four sets of decoded bits 409A through 409D respectively. The CRC check may be applied in block 410 on the four sets of decoded bits 409A through 409D in order to select one 411 of the four sets of decoded bits. The DeepRx 405 in combination with blocks 408A-D and block 410 may provide an example implementation of the DeepRxPilotless model as it may operate on radio frequency signals without pilot data.

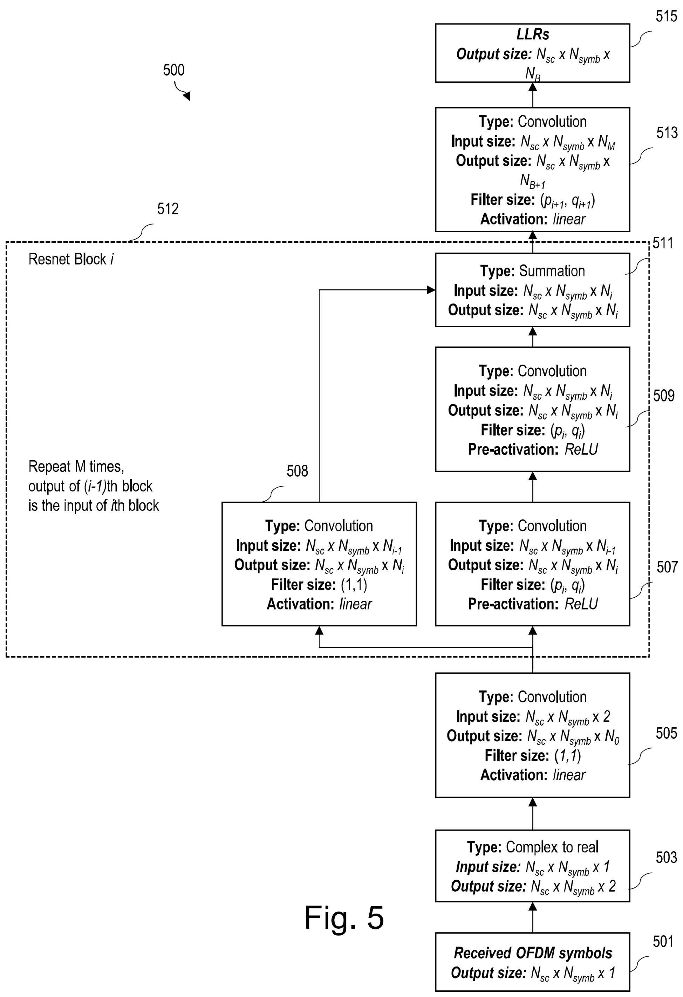

**FIG. 5** is a block diagram illustrating an example of the machine learning model 500 according to an example of the present subject matter. The machine learning model 500 is described for a radio frequency signal received in accordance with a single-input and single-output (SISO) scenario. The frequency-domain received OFDM symbols (501) serve as the input, where *N_{sc}* denotes the number of received subcarriers on the active bandwidth part (BWP) and *N_{symb}* represents the number of OFDM symbols in a slot, typically 14. The frequency-domain received OFDM symbols may be an example of the set of initial modulation symbols. These symbols are first converted from complex to real values (503), producing an output of size *N_{sc}* × *N_{symb}* × 2. This transformation allows subsequent convolutional layers to process the real and imaginary parts separately. The resulting processed array is then fed into a convolutional layer (505) with a (1,1) filter size and a linear activation function, preserving the input structure while mapping it to an output size of *N_{sc}* × *N_{symb}* × *N*₀. The core of the receiver is the Residual Network (ResNet) type CNN, which consists of multiple of ResNet block (512). The ResNet block 512 is repeated M times, where the output of the (*i* - 1)th block serves as the input to the *i*-th block. Within each ResNet block, two key convolutional layers (507, 509) apply one-dimensional (1D) filters, alternating between the frequency domain and the time domain to optimize detection accuracy. The filters used in these layers may follow a pattern where, for example, the first ResNet block may use (15,1) filters (over the frequency domain), followed by (1,15) filters (over the time domain) in the next ResNet block, and so on. This alternation may help achieve a larger receptive field, which is critical for detecting QAM symbols without pilots. A summation operation (511) integrates the skip connection with the processed output. If the number of channels between two consecutive ResNet blocks remains the same, the skip connection's convolutional layer (508) may be omitted. Otherwise, an additional convolution operation with a (1,1) filter size is applied to adjust the number of output channels. The final output from the ResNet blocks is processed by an additional convolutional layer (513) that refines the learned feature representations. The final output layer (515) generates log-likelihood ratios (LLRs), which are the receiver's estimates of the transmitted bits' probabilities. The output size of the LLR layer is *N_{sc}* × *N_{symb}* × *N_{B},* where *N_{B}* represents the number of bits per resource element (RE), corresponding to the modulation order of QAM.

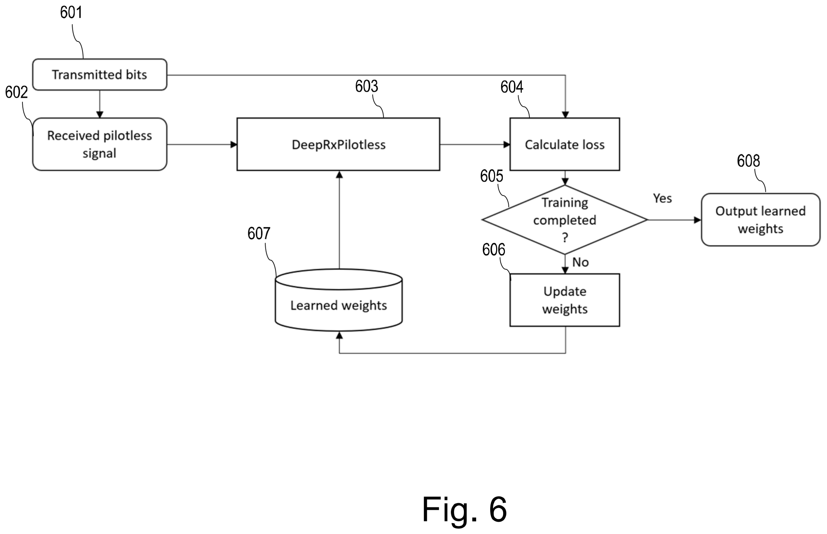

**FIG. 6** is a block diagram illustrating a method for training the machine learning model in accordance with an example of the present subject matter. For the purpose of explanation, the method described in reference to FIG. 6 may be implemented in an apparatus such as the node 114 illustrated and described in reference to FIG. 1 or apparatus illustrated and described in reference to FIG. 9 but is not limited to this implementation. The diagram illustrates the training process for the DeepRxPilotless model, incorporating rotation-independent loss calculation and curriculum-learning-based training. The process begins with the transmitted bits (601) and the corresponding received pilotless signal (602), which is fed into the DeepRxPilotless model (603). The output of the model consists of LLRs, which are used to estimate the transmitted bits. The loss function (604) is then calculated to evaluate the discrepancy between the estimated and actual transmitted bits. This loss calculation accounts for multiple possible rotations of the received constellation. Specifically, the binary cross-entropy (BCE) loss is computed independently for each of the four possible phase rotations (0, -90, 90, and 180 degrees), and the minimum loss value is selected as the final loss, where the rotation 0 represents the original candidate set of LLR-blocks. Following loss calculation, the process enters a training evaluation phase (605), where it is determined whether the model has converged or further updates are required. If training is not yet complete, the model's weights are updated (606) using backpropagation, adjusting the parameters. The updated weights are stored in the learned weights repository (607) and are subsequently used in the next training iteration. This iterative process continues until the training reaches convergence, at which point the final learned weights (608) are output for deployment.

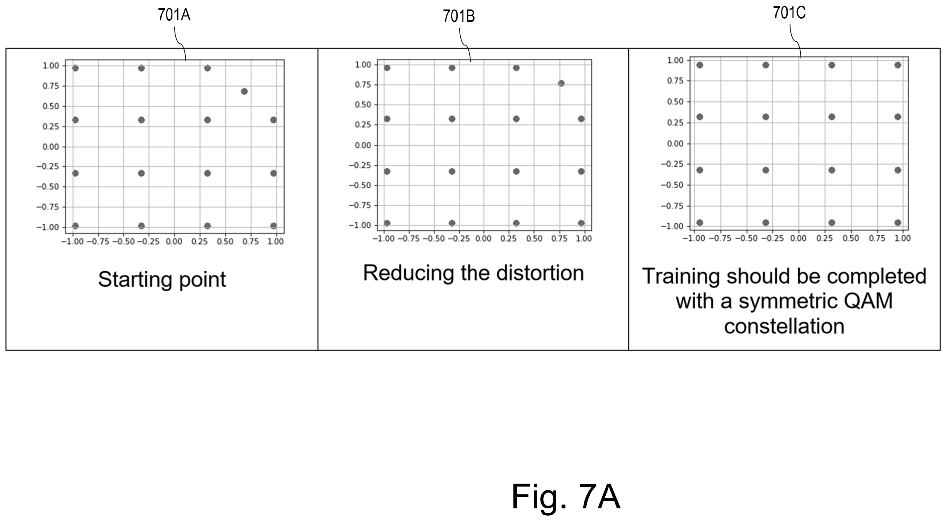

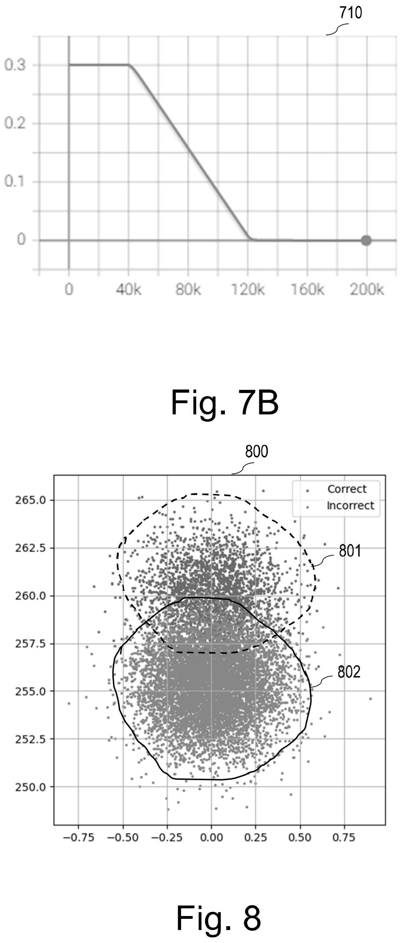

Additionally, the curriculum-learning-based training approach (e.g., as illustrated with FIG. 7A and FIG. 7B) may be incorporated into this process to further enhance model performance. Initially, the training starts with an asymmetric constellation, which DeepRxPilotless model may learn to detect more easily. The asymmetry is maintained for a portion of the training (e.g., 20% of iterations), during which a regular loss function is used without rotation minimization. As training progresses, the asymmetry is gradually reduced until the constellation becomes a standard QAM constellation, enabling the model to generalize to realistic transmission conditions.

The diagram of **FIG. 7A** illustrates the curriculum-learning-based approach for training the machine learning model, showing the progression from an initial distorted constellation (701A) to a fully symmetric QAM constellation (701C). Initially, at the starting point, the constellation (701A) exhibits significant asymmetry and distortion, designed to make the model learn an unambiguous representation of the received symbols. During this phase, the model may be trained using a standard loss function without considering rotation minimization. As training progresses, the distortion is gradually reduced (as illustrated with constellation 701B), shifting the constellation points toward their correct positions in the QAM constellation. This transition is performed linearly, ensuring a smooth adaptation process. During this phase, the model begins to rely on minimum BCE loss across the four possible LLR rotations (0, -90, 90, and 180 degrees), as described herein. The distortion reduction phase may be performed over 40% of the total training iterations. Finally, in the last stage, the training is completed using a fully symmetric QAM constellation, where all constellation points align precisely with their ideal positions. At this point, the machine learning model may be expected to have learned a robust representation of the modulation scheme, allowing it to detect QAM symbols accurately, even in the absence of pilot signals. This progressive learning approach may enhance the model's ability to generalize.

**FIG. 7B** illustrates through a plot 710 the training schedule for reducing asymmetry in the constellation over 200,000 training iterations. The training schedule may, for example, be used to train the machine learning model indicating how to switch between the subsets of the training dataset. Initially, the constellation exhibits a distortion level of 0.3, corresponding to the constellation 701A in FIG. 7A, where the points are significantly displaced from their ideal QAM positions. During the first 40,000 iterations, the distortion remains constant. Following this initial phase, the asymmetry linearly decreases over the next 80,000 iterations, shifting the constellation points toward their ideal locations. This phase corresponds to the constellation 701B in FIG. 7A, where the constellation retains some residual distortion but is progressively aligning with the regular QAM grid. By approximately 120,000 iterations, the distortion reaches 0.0, meaning the constellation is now a fully symmetric QAM constellation. The remaining 80,000 iterations of training are conducted with a distortion-free QAM constellation. This progressive approach may ensure that DeepRxPilotless model may learn robust LLR predictions, even when starting from a distorted constellation.

**FIG. 8** is a plot 800 illustrating the separation between correct and incorrect LLR rotations after a single LDPC iteration, plotted with respect to the first and second statistical moments. This may provide an example implementation of the statistical property for the second LDPC based selection example. The points 801 with dotted boundary represent correctly predicted LLR rotations, while the points 802 encircled with sold boundary correspond to incorrectly predicted ones. This visualization may provide insight into how LDPC decoding begins to distinguish between different rotations based on statistical properties of the LLRs. The first and second moments, which may typically refer to the mean (expected value) and variance, are used as statistical indicators for assessing the likelihood of a particular rotation being correct. The correctly identified LLRs tend to cluster in a different region than the LLRs of the incorrect rotations. This separation may enable the apparatus to apply statistical selection techniques, such as choosing the LLR rotation that exhibits the highest reliability based on these moment-based features. In the broader context of the model, this statistical separation may optimize pilotless detection by allowing early rejection of incorrect rotations.

**In** **FIG. 9****,** a block circuit diagram illustrating a configuration of an apparatus 1070 is shown, wherein the apparatus 1070 is configured to implement at least part of the present subject matter. It is to be noted that the apparatus 1070 illustrated in FIG. 9 may comprise several further elements or functions besides those described herein below, which are omitted herein for the sake of simplicity as they are not essential for the understanding. Furthermore, the apparatus may be also another device having a similar function, such as a chipset, a chip, a module, etc., which can also be part of an apparatus or attached as a separate element to the apparatus 1070, or the like. The apparatus 1070 may comprise a processing function or processor 1071, such as a central processing unit (CPU) or the like, which executes instructions given by programs or the like related to a flow control mechanism. The processor 1071 may comprise one or more processing portions dedicated to specific processing as described below, or the processing may be run in a single processor. Portions for executing such specific processing may be also provided as discrete elements or within one or more further processors or processing portions, such as in one physical processor like a CPU or in several physical entities, for example. Reference sign 1072 denotes transceiver or input/output (I/O) units (interfaces) connected to the processor 1071. The I/O units 1072 may be used for communicating with one or more other network elements, entities, terminals or the like. The I/O units 1072 may be a combined unit comprising communication equipment towards several network elements or may comprise a distributed structure with a plurality of different interfaces for different network elements. Reference sign 1073 denotes a memory usable, for example, for storing data and programs to be executed by the processor 1071 and/or as a working storage of the processor 1071. The processor 1071 is configured to execute processing related to the subject matter described throughout this disclosure. In particular, the apparatus 1070 may be configured to perform the method as described in reference to FIG. 2, 3, 4, 5, or 6.

For example, the processor 1071 is configured for: determining in accordance with a modulation scheme a candidate set of soft bit blocks representing at least part of the data, the set of soft bit blocks representing a set of constellation points in a modulation constellation of the modulation scheme, wherein an application of each geometric transformation operation of a set of geometric transformation operations to a corresponding subset of the set of constellation points or to the set of constellation points, preserves the shape of the modulation constellation but results in representing different data; for each geometric transformation operation of the set of geometric transformation operations, modifying according to the geometric transformation operation corresponding soft bit blocks of the candidate set of soft bit blocks resulting in another candidate set of soft bit blocks; selecting from the candidate sets of soft bit blocks the candidate set of soft bit blocks that likely represents the at least part of the data.

## Claims

1. An apparatus for reception of data in a wireless communication system, the apparatus comprising at least one processor; and at least one memory storing instructions that, when executed by the at least one processor, cause the apparatus to:
determine (201) in accordance with a modulation scheme a candidate set of soft bit blocks representing at least part of the data, the candidate set of soft bit blocks representing a set of constellation points in a modulation constellation of the modulation scheme, wherein an application of each geometric transformation operation of a set of geometric transformation operations to a corresponding subset of the set of constellation points or to the set of constellation points preserves the shape of the modulation constellation but results in data being represented differently;
for each geometric transformation operation of the set of geometric transformation operations, modify (203) according to the geometric transformation operation corresponding soft bit blocks of the candidate set of soft bit blocks resulting in another candidate set of soft bit blocks;
select (205) from the candidate sets of soft bit blocks the candidate set of soft bit blocks that represents the at least part of the data.

2. The apparatus of claim 1, wherein the instructions, when executed by the at least one processor, further cause the apparatus to determine the candidate set of soft bit blocks by at least:
receive a radio frequency signal comprising the at least part of the data;
process the radio frequency signal to obtain a set of modulation symbols;
input the set of modulation symbols to a machine learning model to obtain the candidate set of soft bit blocks.

3. The apparatus of any of the preceding claims, wherein the instructions, when executed by the at least one processor, further cause the apparatus to determine the set of soft bit blocks by at least:
receive a radio frequency signal comprising the at least part of the data;
process the radio frequency signal in accordance with the modulation scheme to obtain the candidate set of soft bit blocks, wherein the radio frequency signal is pilotless excluding reference signal data.

4. The apparatus of any of the preceding claims, wherein the instructions, when executed by the at least one processor, further cause the apparatus to select the candidate set of soft bit blocks by at least:
process the candidate sets of soft bit blocks with a decoding process followed by an error detection process, and selecting the candidate set of soft bit blocks that passed the error detection process.

5. The apparatus of claim 4, the decoding process being a low-density parity check, LDPC, decoding and the error detection processing being a cyclic redundancy check, CRC, check.

6. The apparatus of claim 5, wherein the LDPC decoding is performed for each candidate set of soft bit blocks of the candidate sets of soft bit blocks to obtain a set of decoded bits per candidate set of soft bit blocks, before applying the CRC check on the sets of decoded bits.

7. The apparatus of any of the preceding claims 1 to 3, wherein the instructions, when executed by the at least one processor, further cause the apparatus to select the candidate set of soft bit blocks by at least:
perform a first iteration of a low-density parity check, LDPC, decoding for each candidate set of soft bit blocks of the candidate sets of soft bit blocks to obtain an intermediate set of decoded bits per candidate set of soft bit blocks;
select one intermediate set of decoded bits based on a statistical property of the intermediate sets of decoded bits;
complete the LDPC decoding on the selected intermediate set of decoded bits to obtain a set of decoded bits, wherein the selected candidate set of soft bit blocks is the candidate set of soft bit blocks associated with the selected intermediate set of decoded bits.

8. The apparatus of any of the preceding claims 1 to 3, wherein the instructions, when executed by the at least one processor, further cause the apparatus to select the candidate set of soft bit blocks by at least:
repeatedly:
perform a current iteration of an LDPC decoding for each candidate set of soft bit blocks of the candidate sets of soft bit blocks to obtain an intermediate set of decoded bits per candidate set of soft bit blocks; and select one intermediate set of decoded bits on a statistical property of the intermediate sets of decoded bits; wherein the repetition is performed until the intermediate set of decoded bits is selected;
complete the LDPC decoding on the selected intermediate set of decoded bits to obtain a set of decoded bits, wherein the selected candidate set of soft bit blocks is the candidate set of soft bit blocks associated with the selected intermediate set of decoded bits.

9. The apparatus of claim 7 or 8, wherein the instructions, when executed by the at least one processor, further cause the apparatus to select the intermediate set of decoded bits by at least one of:
calculating an average magnitude, representing the statistical property, of each intermediate set of decoded bits and selecting the intermediate set of decoded bits that has the highest average magnitude; or
calculating predefined moments, representing the statistical property, from the intermediate sets of decoded bits and inputting the moments to a neural network, which has been trained to select a correct intermediate set of decoded bits based on the input.

10. The apparatus of any of the preceding claims, the modulation scheme being a quadrature amplitude modulation (QAM), wherein the set of geometric transformation operations are rotation operations.

11. The apparatus of any of the preceding claims 2 to 10, wherein the machine learning model is a convolutional neural network comprising multiple convolutional layers, where the convolutional layers implement one-dimensional filters, alternating between dimensions corresponding to a frequency domain and a time domain of the at least part of the data.

12. The apparatus of any of the preceding claims 2 to 11, wherein an operation comprises the determining of the candidate set of soft bit blocks and the modifying, wherein the instructions, when executed by the at least one processor, further cause the apparatus to train the machine learning model comprising: perform the operation on a training radio frequency signal to obtain training candidate sets of soft bit blocks, evaluate for each training candidate set of the soft bit blocks of the training candidate sets of soft bit blocks a loss function, resulting in multiple values of the loss function; wherein the instructions, when executed by the at least one processor, further cause the apparatus to:
use the smallest value of the multiple values to update the machine learning model and repeat the training or provide the machine learning model.

13. The apparatus of claim 12, wherein the training is performed using a training dataset comprising entries, each entry represents a training set of initial modulation symbols in accordance with the modulation scheme obtained from the training radio frequency signal, wherein the entries represent different shapes of the modulation constellation, wherein the shapes have an asymmetry that is progressively reduced during the training until the shape of the modulation constellation becomes a regular shape of the modulation scheme.

14. The apparatus of any of the preceding claims, wherein the instructions, when executed by the at least one processor, further cause the apparatus to process the selected candidate set of soft bit blocks using an, error-control decoding process to recover the at least part of data.

15. A method for reception of data in a wireless communication system, the method comprising:
determining (201) in accordance with a modulation scheme a candidate set of soft bit blocks representing at least part of the data, the set of soft bit blocks representing a set of constellation points in a modulation constellation of the modulation scheme, wherein an application of each geometric transformation operation of a set of geometric transformation operations to a corresponding subset of the set of constellation points or to the set of constellation points, preserves the shape of the modulation constellation but results in data being represented differently;
for each geometric transformation operation of the set of geometric transformation operations, modifying (203) according to the geometric transformation operation corresponding soft bit blocks of the candidate set of soft bit blocks resulting in another candidate set of soft bit blocks;
selecting (205) from the candidate sets of soft bit blocks the candidate set of soft bit blocks that likely represents the at least part of the data.
